# EUROPÄISCHE PATENTSCHRIFT

(11) **EP 3 408 895 B1**
(45) Veröffentlichungstag und Bekanntmachung des Hinweises auf die Patenterteilung: **20.01.2021**
(21) Anmeldenummer: 17708673.3
(22) Anmeldetag: 26.01.2017
(51) Int. Cl.: H01R 12/52, H01R 12/73, H01R 29/00, H01R 4/30, H01R 41/00, H05K 1/14, H01R 12/71, H01R 13/26

(54) **LINEARBEWEGLICHES GLEITKONTAKTSYSTEM UND VERFAHREN ZUR HERSTELLUNG**
LINEARLY MOVEABLE SLIDING CONTACT SYSTEM AND PRODUCTION METHOD
SYSTÈME DE CONTACT GLISSANT À MOUVEMENT LINÉAIRE ET SON PROCÉDÉ DE FABRICATION

(30) Priorität: 29.01.2016 DE 102016101629
(43) Veröffentlichungstag der Anmeldung: 05.12.2018
(73) Patentinhaber: HARTING Electronics GmbH, 32339 Espelkamp (DE)
(72) Erfinder: WOLF, Torsten, 32312 Lübbecke (DE); ROSE, Dieter, 32369 Rahden (DE)
(86) Internationale Anmeldenummer: PCT/DE2017/100049
(87) Internationale Veröffentlichungsnummer: WO 2017/129179

(56) Entgegenhaltungen:
- EP-A2- 2 385 404
- WO-A1-2017/000936
- GB-A- 2 145 581
- US-A1- 2014 308 829

## Beschreibung

Die Erfindung betrifft ein linearbewegliches Gleitkontaktsystem mit Transportvorrichtung aufweisend ein Gleitkontaktelement, einen Grundkörper, welcher das Gleitkontaktelement bildet, und eine Spindel, welche die Transportvorrichtung bildet, wobei der Grundkörper zumindest eine Aufnahme aufweist, in welcher ein elektrischer Kontakt aufgenommen ist, wobei der elektrische Kontakt zumindest zwei Kontaktbereiche bildet, welche an gegenüberliegenden Seiten des Grundkörpers aus dem Grundkörper herausragen, wobei die Spindel länglich ausgebildet ist und zumindest bereichsweise ein Außengewinde aufweist, und wobei der Grundkörper ein Innengewinde aufweist, in welches das Außengewinde er Spindel einschraubbar ist. Ferner betrifft die Erfindung ein Verfahren zur Herstellung eines solchen Gleitkontaktelementes mit Transportvorrichtung.

In der DE 10 2005 035104 C5 ist ein Möbelantrieb mit Weggeber offenbart. Dabei wird ein elektromotorischer Antrieb mit einem absoluten Weggeber genutzt, welcher an die Länge des Verstellweges anpassbar ist und eine Positionsinformation auch bei einer Schnellentriegelung bestehen bleibt.

Aus der DE 10 2015 110 498 B3 ist ein Gleitelement zur Kontaktierung von Leiterkarten bekannt. Dabei werden die Leiterbahnen von zwei, gegenüberliegenden Leiterkarten kontaktiert

Das Dokument US 2014308829 A1 offenbart ebenfalls ein linearbewegliches Gleitkontaktsystem.

Derartige linearbewegliche Gleitkontaktelemente mit Transportvorrichtung werden benötigt, um Leiterbahnen von parallel zueinander ausgerichteten, übereinander angeordneten Leiterkarten elektrisch miteinander zu kontaktieren. Dabei sind die Leiterkarten in sehr engem Abstand zueinander angeordnet und weisen eine Vielzahl von Leiterbahnen auf, welche je nach Anwendung und Schaltung unterschiedlich miteinander kontaktiert werden müssen.

Je nach Anwendung können mehrere Leiterbahnen der Leiterkarten gleichzeitig durch mehrere Gleitkontaktelemente verbunden werden. Durch Verschieben (Gleiten) der Gleitkontaktelemente zwischen den Leiterkarten können unterschiedliche Positionen und so unterschiedliche elektrische Verbindungen und Schaltkreise geschlossen werden. Das Gleitkontaktelement berührt dabei die beiden Leiterkarten, zwischen welchen es angeordnet ist, mit einem elektrischen Kontakt. So wird eine elektrische Verbindung zwischen der Leiterbahn der einen Leiterkarte und der Leiterbahn der anderen Leiterkarte hergestellt.

Eine feste Verdrahtung oder Verkabelung ist für derartige Anwendungen z.B. in einem Verteilerkasten für Telefonleitungen nicht zweckmäßig, da die elektrischen Verbindungen von Zeit zu Zeit geändert, ersetzt und neue verkabelt werden müssen. Eine übliche Verkabelung mit Steckverbindern und Kabeln ist dafür sehr aufwendig. Für jede Änderung muss ein Kabel entfernt und an einer anderen Stelle ein Kabel hinzugefügt und elektrisch verbunden werden. Für diese Arbeiten muss jeweils ein Mitarbeiter vor Ort an den entsprechenden Verteilerkasten fahren und die neue Verkabelung manuell vornehmen. Dies ist sehr zeit- und kostenintensiv.

Ein weiterer Nachteil bekannter Verkabelungen ist der große Bedarf an Raum. Da die Verkabelungen von Hand getätigt werden, benötigt ein derartiger Schaltschrank für jede mögliche Anschlussposition einen Steckverbinder oder zumindest einen Anschlusspunkt für Litzenleiter. Diese sind sehr groß im Vergleich zu den eigentlichen elektrischen Leitungen, die miteinander verbunden werden sollen. Daher wird deutlich mehr Bauraum für eine manuelle Verkabelung benötigt als für die eigentliche, elektrische Kontaktierung nötig wäre.

Derartige Vorrichtungen werden in besonders großen Stückzahlen benötigt. Da beispielsweise für jeden Leitungsanschluss einer Telefonanlage eine Leitung, bestehend aus zwei Adern, kontaktiert werden muss, summiert sich die Anzahl solcher Kontaktelemente in einer automatisierten Zentrale schnell auf mehrere Tausend. Die Montage einer solchen Anlage ist daher sehr aufwendig und teuer. Neben kurzen Arbeits- und Montagezeiten ist zudem auf geringe Stückkosten zu achten, um den Einsatz einer großen Anzahl derartiger Kontaktelemente wirtschaftlich zu gestalten.

### Aufgabenstellung

Der Erfindung liegt daher die Aufgabe zugrunde, ein linearbewegliches Gleitkontaktsystem mit Transportvorrichtung der eingangs beschriebenen Art vorzustellen, welches sich durch eine kostengünstige Herstellung sowie schnelle Montagemöglichkeit auszeichnet, sowie um ein geeignetes Verfahren zur Herstellung.

Die Aufgabe wird durch die kennzeichnenden Merkmale der unabhängigen Ansprüche 1 und 11 gelöst.

Vorteilhafte Ausgestaltungen der Erfindung sind in den Unteransprüchen angegeben.

Bei der Erfindung handelt es sich um ein linearbewegliches Gleitkontaktsystem mit Transportvorrichtung zur elektrischen Kontaktierung von Leiterbahnen gegenüberliegender Leiterkarten. Dabei sind zwei Leiterkarten parallel, in einem geringen Abstand zueinander angeordnet. Auf der jeweils der anderen Leiterkarte zugewandten Seite sind auf den Leiterkarten elektrische Leiterbahnen vorgesehen. Je nach Anwendung und Verschaltung der beiden Leiterkarten zueinander müssen unterschiedliche, auf den Leiterkarten vorgesehene, gegenüberliegende Leiterbahnen elektrisch miteinander verbunden werden.

Das Gleitkontaktelement ist aus einem Grundkörper gebildet, welcher zur Aufnahme von zumindest einem elektrischen Kontakt vorgesehen ist. Vorzugsweise ist der Grundkörper als einteiliges Spritzgussteil aus einem Polymer hergestellt. Zweckmäßig ist das Polymer elektrisch nicht leitfähig, d.h. elektrisch isolierend. Der Grundkörper weist zumindest eine Aufnahme auf, in welcher der zumindest eine elektrische Kontakt eingesetzt und fixiert werden kann.

Um die gattungsgemäße Aufgabe erfüllen zu können, ist der elektrische Kontakt so im Grundkörper angeordnet, dass er an zwei gegenüberliegenden Seiten des Grundkörpers aus diesem herausragt. Der elektrische Kontakt bildet so zwei außerhalb des Grundkörpers angeordnete Kontaktbereiche. Die Kontaktbereiche sind zur elektrischen Kontaktierung zweier Leiterplatten vorgesehen, zwischen welchen das Gleitkontaktelement angeordnet ist.

Im Grundkörper ist eine Bohrung vorgesehen, die den Grundkörper vollständig durchdringt. Die Bohrung ist mit einem Innengewinde versehen. Erfindungsgemäß ist das Innengewinde lediglich als erstes Gewindesegment ausgebildet. D.h. dass das Innengewinde nur über 180° ausgeformt ist und nicht über vollständige 360° der Bohrung.

In dem Gleitkontakt des Gleitkontaktsystems nach der Erfindung ist im Grundkörper eine erste Offnung vorgesehen, welche sich gegenüber dem ersten Gewindesegment befindet. Durch die erste Öffnung im Grundkörper ist so das erste Gewindesegment zugänglich. Dies ist besonders vorteilhaft für eine einfache, kostengünstige Herstellung im Spritzgussverfahren. Es muss keine Aufwendige Spritzgussform mit beweglichen Einzelteilen angefertigt werden. Die Verwendung einer einfachen, zweiteiligen Spritzgussform ist durch das über die erste Öffnung zugängliche erste Gewindesegment möglich.

Eine spezielle Ausführungsform sieht vor, dass in dem Grundkörper zwei weitere, zweite Öffnungen vorgesehen sind. Die zweiten Öffnungen sind dabei vor und nach dem ersten Gewindesegment, gegenüber der ersten Öffnung im Grundkörper angeordnet. Die zweiten Öffnungen reichen bis in die Bohrung durch den Grundkörper, so kann mittels der zweiten Öffnungen der Grundkörper sehr materialsparend und kostengünstig hergestellt werden.

Die Transportvorrichtung ist ebenfalls ein aus einem Polymer, erfindungsgemäß im Spritzgussverfahren hergestelltes Bauteil. Die Transportvorrichtung ist länglich ausgebildet und bildet im Hauptbestandteil eine Spindel, die über ihre Länge ein Außengewinde aufweist. An den beiden Enden der Spindel ist jeweils ein Lager vorgesehen. Die Lager sind zur Aufnahme und Lagerung der Transportvorrichtung zwischen zwei Leiterkarten vorgesehen.

An einem ersten der beiden Lager ist auf der dem Außengewinde abgewiesenen Seite des Lagers zusätzlich eine Kupplung vorgesehen. Die Kupplung kann dabei zweckmäßig verschieden ausgebildet sein. Sie dient zur Kuppeln der Transportvorrichtung an einem Motor oder eine andere Vorrichtung die es ermöglicht, die Transportvorrichtung in eine Drehbewegung zu versetzen. Vorteilhaft ist die Kupplung so ausgestaltet, dass sie mittels einer einfachen Mechanik betätigt werden kann.

In einer bevorzugten Ausführungsform ist das Außengewinde in einem begrenzten Bereich am zweiten der beiden Lager nur als zweites Gewindesegment ausgebildet. Das Außengewinde ist in diesem Bereich nur auf einer Hälfte der Spindel vorhanden. Die andere Hälfte der Spindel ist glatt, ohne Gewinde ausgeführt. Das Außengewinde ist somit in dem begrenzten Bereich nur auf 180° um die Spindel vorhanden.

Die Spindel und das Außengewinde an der Spindel sind so ausgebildet, dass die Spindel in dem Gleitkontaktelement aufgenommen werden kann. Das Außengewinde der Spindel ist in das Innengewinde des Gleitkontaktelements einschraubbar. Durch drehen der Spindel kann das Gleitkontaktelement so linear bewegt werden. Die Transportvorrichtung ist so ausgelegt das Gleitkontaktelement linear bewegen zu können. Je nach Drehung der Transportvorrichtung mittels eines Antriebs, welcher die Transportvorrichtung an der Kupplung dreht, kann das Gleitkontaktelement bewegt werden.

Eine spezielle Ausführungsform sieht vor, dass der Grundkörper des Gleitkontaktelements und die Transportvorrichtung einteilig ausgebildet sind und über einen Steg miteinander verbunden. Dies ist besonders vorteilhaft um beide Bestandteile in einem Spritzgussvorgang herzustellen. Der Grundkörper und die Transportvorrichtung können so einteilig produziert und transportiert werden. Der Steg ist vorteilhaft als Sollbruchstelle ausgebildet. Der Grundkörper und die Transportvorrichtung können so einfach voneinander getrennt werden. Die elektrischen Kontakte können direkt in den noch mit der Transportvorrichtung verbundenen Grundkörper eingesetzt werden. So liegt vorteilhaft nur ein Stück vor, welches kommissioniert werden muss.

Ein weiterer Vorteil der einteiligen Produktion von Grundkörper und Transportvorrichtung ist, dass bei der Herstellung der Spritzgussformen - welche meist gleich mehrere Kavitäten-Paare aufweisen - jeweils die Gewinde von Grundkörper und Transportvorrichtung nur paarweise aufeinander abgestimmt werden müssen. Würde man aus einer Spritzgussform mehrere Grundkörper und mehrere Transportvorrichtungen gleichzeitig entformen, müsste alle produzierten Teile, also vorrangig die Gewinde, zueinander passen und kompatibel sein. Dadurch, dass immer gleich Grundkörper-Transportvorrichtungs-Paare produziert werden, müssen lediglich die jeweiligen Gewinde aufeinander abgestimmt sein. Dies verringert die Produktionskosten und Aufwand der Spritzgussform.

Zur Montage des linearbeweglichen Gleitkontaktelements mit Transportvorrichtung muss lediglich die Transportvorrichtung vom Grundkörper getrennt oder abgebrochen werden und in diesen eingesetzt werden. Durch die vorteilhafte Ausgestaltung der Gewinde ist die Transportvorrichtung bereits nach einer halben Umdrehung mit dem Grundkörper verbunden. Die Erfindung ermöglicht somit eine einfache, kostengünstige Produktion, Kommissionierung sowie Montage des linearbeweglichen Gleitkontaktelements mit Transportvorrichtung.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung eines linearbeweglichen Gleitkontaktelements mit Transportvorrichtung;
- Fig. 2: eine Detailansicht eines Gleitkontaktelements;
- Fig. 3: eine Schnittdarstellung eines Gleitkontaktelements;
- Fig. 4: eine weitere Detailansicht eines Gleitkontaktelements;
- Fig. 5: eine Schnittdarstellung eines Gleitkontaktelements mit Transportvorrichtung;
- Fig. 6: eine weitere Schnittdarstellung eines Gleitkontaktelements mit Transportvorrichtung; und
- Fig. 7: eine Schnittdarstellung eines Grundkörpers mit verbundener Transportvorrichtung.

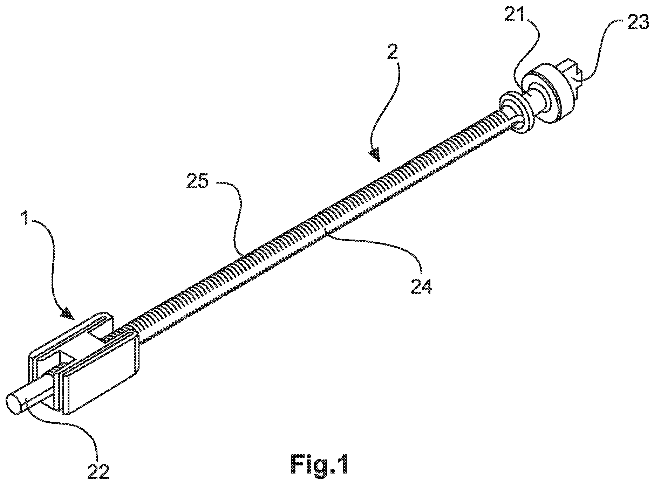

Die Figur 1 zeigt eine perspektivische Darstellung eines erfindungsgemäßen, linearbeweglichen Gleitkontaktelements 1 mit Transportvorrichtung 2. Die Transportvorrichtung 2 ist als Spindel 24 ausgebildet. Die Spindel 24 ist als zylindrischer Körper ausgebildet und verfügt über ein Gewinde, welches als Außengewinde 25 um die Spindel herum angeformt ist.

Die Spindel 24 bildet ein erstes Ende und ein zweites Ende, wobei das erste Ende ein erstes Lager 21 aufweist und das zweite Ende ein zweites Lager 22 aufweist. Die Lager 21, 22 sind zur Lagerung der Transportvorrichtung 2 zwischen zwei Leiterkarten vorgesehen. Dazu sind die Lager 21, 22 in Gegenlager aufnehmbar, in welchen sie drehbar gelagert sind.

Am ersten Ende weist die Spindel 24 eine hinter dem Lager 21 die Transportvorrichtung 2 abschließende Kupplung 23 auf. Die Kupplung 23 ist als länglicher Zapfen ausgebildet. Mittels einer Gegenkupplung kann über die Kupplung 23 die Transportvorrichtung gedreht werden.

Das Gleitkontaktelement 1 ist auf die Transportvorrichtung 2 aufgesetzt und mittels eines Innengewindes auf der Transportvorrichtung 2 fixiert. Über eine Drehung der Transportvorrichtung 2 kann das Gleitkontaktelement 1 linear entlang der Transportvorrichtung 2 bewegt werden.

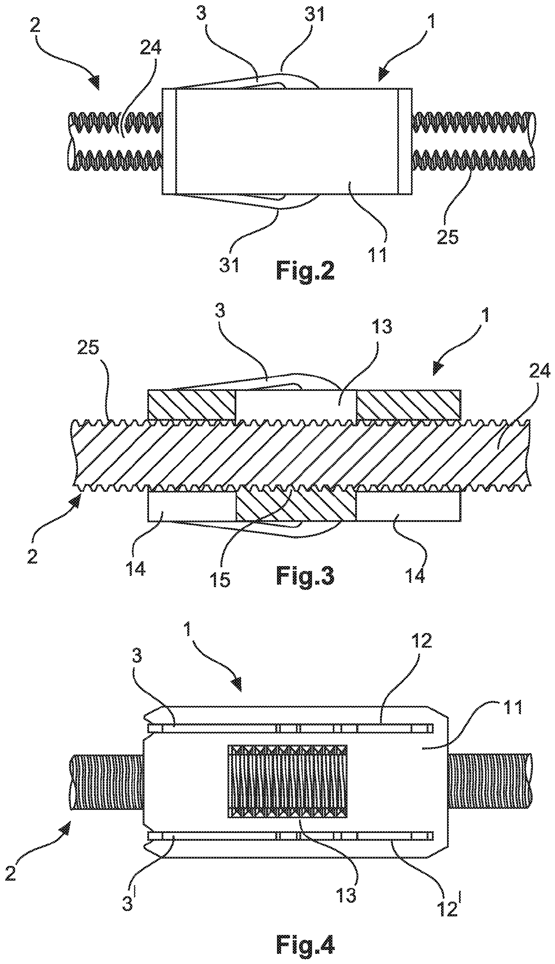

Eine Detailansicht des Gleitkontaktelements 1 ist in der Figur 2 dargestellt. Das Gleitkontaktelement 1 wird aus einem Grundkörper 11 gebildet, welcher auf der Spindel 24 aufgesetzt und geführt ist. Im Grundkörper 11 sind zudem zwei elektrische Kontakte 3 aufgenommen. Die elektrischen Kontakte 3 sind so ausgebildet, dass sie zwei Kontaktbereiche 31 bilden. Die Kontaktbereiche 31 ragen an zwei gegenüberliegenden Seiten des Grundkörpers 11 aus diesem heraus. Dadurch können zwei Leiterkarten, zwischen welchen das Gleitkontaktelement 1 angeordnet ist, elektrische miteinander verbunden werden.

In der Figur 3 ist die Detailansicht der Figur 2 noch einmal in einer Schnittdarstellung gezeigt. Erkennbar ist die Spindel 24 mit dem Außengewinde 25, welche sich durch den Grundkörper 11 des Gleitkontaktelements 1 erstreckt. Im Grundkörper 11 ist ein Innengewinde eingeformt, in welches das Außengewinde 25 der Transportvorrichtung eingeschraubt ist.

In den Grundkörper ist im Bereich des Innengewindes eine erste Öffnung 13 eingebracht. Die erste Öffnung 13 reicht so weit in den Grundkörper 11, dass das Innengewinde nur als Gewindesegment 15 ausgebildet ist. Durch die Öffnung 13 kann das Gewindesegment 15 in einem Spritzgusswerkzeug einfach erzeugt werden. Zudem sind zwei zweite Öffnungen 14 seitlich des Gewindesegments 15 in den Grundkörper 11 eingebracht. Durch die Öffnungen 14 kann ebenso mittels eines Spritzgusswerkzeugs die Führung oberhalb der Spindel 24 erzeugt werden. Die Öffnungen 13, 14 ermöglichen so die einfache Entformung des Grundkörpers 11 in einem Spritzgusswerkzeug in einem Schritt.

Eine weitere Detailansicht des Gleitkontaktelements 1 ist in der Figur 4 dargestellt. Die Ansicht der Figur 4 ist um 90° gedreht zu der Ansicht der Figur 2. Sichtbar ist die Öffnung 13, durch welche das Außengewinde 25 der Spindel 24 erkennbar ist.

Beidseitig der Öffnung 13 und der Transportvorrichtung 2 ist jeweils eine Aufnahme 12 in den Grundkörper 11 eingeformt. In den Aufnahmen 12 sind elektrische Kontakte 3, 3' aufgenommen. Die Aufnahmen 12 sind dabei schlitzartig in den Grundkörper 11 eingeformt, so dass die elektrischen Kontakte 3, 3' beidseitig aus dem Grundkörper 11 mit ihren Kontaktbereichen 31 herausragen.

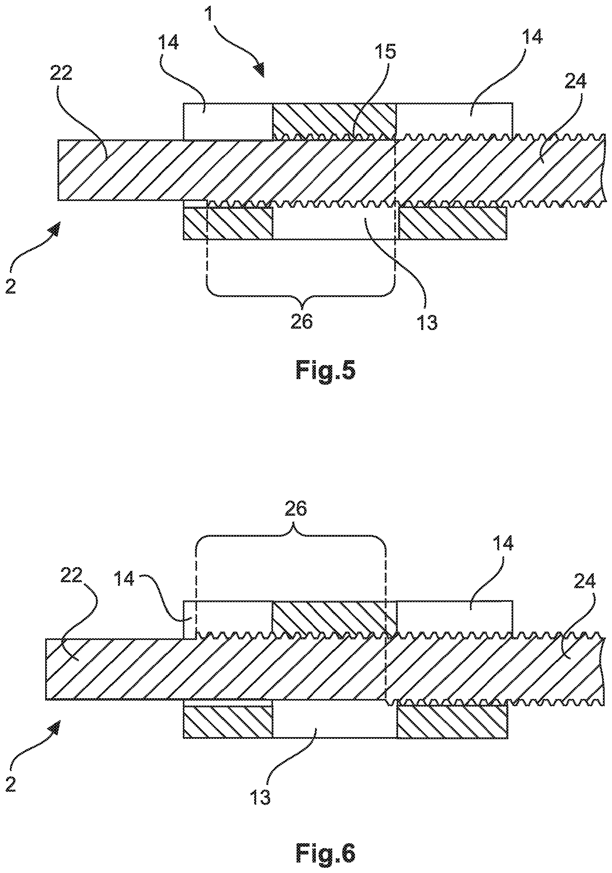

Eine Schnittdarstellung eines Gleitkontaktelements mit Transportvorrichtung ist in der Figur 5 gezeigt. Das Außengewinde 25 ist in einem Bereich 26 am zweiten Lager 22 als zweites Gewindesegment ausgebildet. D.h. dass das Außengewinde 25 im Bereich 26 nur auf der halben Spindelfläche, auf 180° des Umfangs ausgeprägt ist.

Wie in der Figur 5 erkennbar, dient das halbe Außengewinde 25 im Bereich 26 in Kombination mit dem ersten Gewindesegment 15 im Grundkörper 11 einer einfachen, schnellen Montage des Gleitkontaktelements 1 auf die Transportvorrichtung 2. Durch die zwei, nur auf 180° ausgeprägten Gewinde ist es möglich die Spindel 24 soweit in den Grundkörper 11 zu stecken, dass das zweite Lager 22 bereits aus diesem herausragt. Mit eine Drehung von weniger als 360° greifen die beiden Gewinde 15, 25 bereits ineinander und eine vollständige Funktion ist gegeben.

Die Baugruppe aus Figur 5 ist in der Figur 6 mit einer um 180° gedrehten Spindel 24 gezeigt. Hier greifen die Gewinde 15, 25 bereits voll ineinander, obwohl die Transportvorrichtung 2 lediglich um 180° gedreht wurde. Das ermöglicht eine einfache, schnelle Montage der Vorrichtung und spart das Einschrauben der Transportvorrichtung 2 in das Gleitkontaktelement 1 mit ca. 15 Umdrehungen.

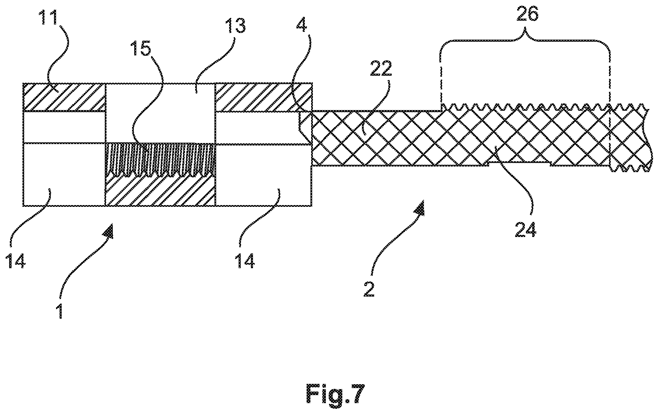

Die Figur 7 zeigt eine Schnittdarstellung eines Grundkörpers 11 mit verbundener Transportvorrichtung 2. Die Figur 7 stellt dabei den Produktionszustand von Grundkörper 11 und Transportvorrichtung 2 dar. Erfindungsgemäß werden der Grundkörper 11 und die Transportvorrichtung 2 einteilig in einem Spritzgussverfahren hergestellt. Grundkörper 11 und Transportvorrichtung 2 sind über einen Steg 4 miteinander verbunden um einen einteiligen Spritzgussprozess zu ermöglichen.

Zweckmäßig ist der Steg 4 gleichzeitig als Sollbruchstelle ausgebildet. Zur Montage der Vorrichtung müssen lediglich noch zwei elektrische Kontakte 3, 3' in den Grundkörper 1 eingesetzt werden, die Transportvorrichtung 2 vom Grundkörper 11 getrennt wird, in diesen eingesteckt und daraufhin um 180° gedreht wird.

## Patentansprüche

1. Linearbewegliches Gleitkontaktsystem mit Transportvorrichtung zur Kontaktierung zweier Leiterkarten,
aufweisend ein Gleitkontaktelement (1), einen Grundkörper (11), welcher das Gleitkontaktelement (1) bildet, und eine Spindel (24), welche die Transportvorrichtung (2) bildet,
wobei der Grundkörper (11) zumindest eine Aufnahme (12) aufweist, in welcher ein elektrischer Kontakt (3) aufgenommen ist,
wobei der elektrische Kontakt (3) zumindest zwei Kontaktbereiche (31) bildet, welche an gegenüberliegenden Seiten des Grundkörpers (11) aus dem Grundkörper (11) herausragen,
wobei die Spindel (24) länglich ausgebildet ist und zumindest bereichsweise ein Außengewinde (25) aufweist, und
wobei der Grundkörper (11) eine Bohrung mit einem Innengewinde aufweist, in welches das Außengewinde (25) der Spindel (24) einschraubbar ist,
**wobei**
das Innengewinde im Grundkörper (11) als ein erstes Gewindesegment (15) ausgebildet ist,
dass die Transportvorrichtung (2) an einem ersten Ende der Spindel (24) ein erstes Lager (21) aufweist, und an einem zweiten Ende der Spindel (24) ein zweites Lager (22) aufweist, und
dass das Außengewinde (25) der Spindel (24) an der zum zweiten Lager (22) ausgerichteten Seite über einen Bereich (26) als zweites Gewindesegment ausgebildet ist, und
der Grundkörper (11) an der dem ersten Gewindesegment (15) gegenüberliegenden Seite eine erste Öffnung (13) aufweist.

2. Linearbewegliches Gleitkontaktsystem mit Transportvorrichtung nach Anspruch 1,
**wobei**
das erste Gewindesegment (15) in einem Winkelbereich zwischen 45 Grad und 180 Grad der Bohrung, vorzugsweise in einem Winkelbereich zwischen 90 Grad und 180 Grad ausgebildet ist.

3. Linearbewegliches Gleitkontaktsystem mit Transportvorrichtung nach Anspruch 1 oder 2,
**wobei**
der Grundkörper (11) in zumindest einem Bereich neben dem ersten Gewindesegment (15) eine zweite Öffnung (14) aufweist, wobei die mindestens eine zweite Öffnung (14) der ersten Öffnung (13) gegenüberliegt..

4. Linearbewegliches Gleitkontaktsystem mit Transportvorrichtung nach Anspruch 1,
**wobei**
die Transportvorrichtung (2) an der der Spindel (24) gegenüberliegenden Seite des ersten Lagers (21) eine Kupplung (23) aufweist.

5. Linearbewegliches Gleitkontaktsystem mit Transportvorrichtung nach Anspruch 1,
**wobei**
das zweite Gewindesegment in einem Winkelbereich zwischen 180 Grad und 315 Grad um die Spindel, vorzugsweise in einem Winkelbereich zwischen 180 Grad und 270 Grad ausgebildet ist.

6. Linearbewegliches Gleitkontaktsystem mit Transportvorrichtung nach Anspruch 5,
**wobei**
das erste Gewindesegment (15) und das zweite Gewindesegment zusammen einen Winkelbereich zwischen 350 Grad und 360 Grad ergeben.

7. Linearbewegliches Gleitkontaktsystem mit Transportvorrichtung nach Anspruch 6,
**wobei**
das erste Gewindesegment (15) und das zweite Gewindesegment jeweils auf zwei oder mehrere Winkelbereiche aufgeteilt sind, wobei die Winkelbereiche des ersten Gewindesegments (15) und des zweiten Gewindesegments ineinanderfügbar sind.

8. Linearbewegliches Gleitkontaktsystem mit Transportvorrichtung nach einem der vorstehenden Ansprüche,
**wobei**
der Grundköper (11) aus einem elektrisch isolierenden Polymer besteht.

9. Linearbewegliches Gleitkontaktsystem mit Transportvorrichtung nach einem der vorstehenden Ansprüche,
**wobei**
die Transportvorrichtung (2) aus einem elektrisch isolierenden Polymer besteht.

10. Verfahren zur Herstellung eines linearbeweglichen Gleitkontaktsystems mit Transportvorrichtung nach einem der vorstehenden Ansprüche,
**wobei**
der Grundkörper (11) und die Transportvorrichtung (2) über einen Steg (4) miteinander verbunden in einem einteiligen Spritzgussverfahren hergestellt werden, und
dass zwei elektrische Kontakte 3, 3' in den Grundkörper 1 eingesetzt werden, die Transporteinrichtung 2 vom Grundkörper 1 getrennt wird, in diesen eingesteckt und daraufhin um 180° gedreht wird.

11. Verfahren nach Anspruch 10,
**wobei**
der Steg (4) als Sollbruchstelle hergestellt ist.

## Claims

1. A linearly movable sliding contact system with transport device for the contacting of two printed circuit boards,
having a sliding contact element, a base body (11), which forms the sliding contact element (1), and a spindle (24), which forms the transport device (2), wherein the base body (11) has at least one receptacle (12) in which an electrical contact (3) is received, wherein the electrical contact (3) forms at least two contact regions (31), which project out of the base body (11) at opposite sides of the base body (11), wherein the spindle (24) has an elongated form and has an external thread (25), at least in certain regions, and wherein the base body (11) has a bore having an internal thread into which the external thread (25) of the spindle (24) may be screwed,
**wherein**
the internal thread in the base body (11) is formed as a first threaded segment (15), in that the transport device (2) has a first bearing (21) at a first end of the spindle (24) and a second bearing (22) at a second end of the spindle (24), and in that, at the side aligned towards the second bearing (22), the external thread (25) of the spindle (24) is formed as a second threaded segment over a region (26), and the base body (11) has a first opening (13) on the side opposite the first threaded segment (15).

2. The linearly movable sliding contact system with transport device as claimed in claim 1,
**wherein**
the first threaded segment (15) is formed in an angular region between 45 degrees and 180 degrees of the bore, preferably in an angular region between 90 degrees and 180 degrees.

3. The linearly movable sliding contact system with transport device as claimed in claim 1 or 2,
**wherein**
the base body (11) has a second opening (14) in at least one region near to the first threaded segment (15), wherein the at least one second opening (14) is opposite the first opening (13).

4. The linearly movable sliding contact system with transport device as claimed in claim 1,
**wherein**
the transport device (2) has a coupling (23) on the side of the first bearing (21) which is opposite the spindle (24).

5. The linearly movable sliding contact system with transport device as claimed in claim 1,
**wherein**
the second threaded segment is formed in an angular region between 180 degrees and 315 degrees around the spindle, preferably in an angular region between 180 degrees and 270 degrees.

6. The linearly movable sliding contact system with transport device as claimed in claim 5,
**wherein**
the first threaded segment (15) and the second threaded segment together produce an angular region between 350 base and 360 degrees.

7. The linearly movable sliding contact system with transport device as claimed in claim 6,
**wherein**
the first threaded segment (15) and the second threaded segment are each divided into two or more angular regions, wherein the angular regions of the first threaded segment (15) and the second threaded segment may be joined to one another.

8. The linearly movable sliding contact system with transport device as claimed in one of the preceding claims,
**wherein**
the base body (11) is made from an electrically insulating polymer.

9. The linearly movable sliding contact system with transport device as claimed in one of the preceding claims,
**wherein**
the transport device (2) is made from an electrically insulating polymer.

10. A method for producing a linearly movable sliding contact system with transport device as claimed in one of the preceding claims,
**wherein**
the base body (11) and the transport device (2) are connected to one another via a web (4) in one-part injection molding procedure, and in that two electrical contacts 3, 3' are inserted into the base body 1, the transport device 2 is separated from base body 1, pushed therein and then rotated through 180°.

11. The method as claimed in claim 10,
**wherein**
the web (4) is produced as a predetermined breaking point.

## Revendications

1. Système de contact glissant à mouvement linéaire et à dispositif de transport pour la mise en contact de deux cartes de circuits imprimés, comportant un élément de contact glissant (1),
un corps de base (11) qui forme l'élément de contact glissant (1), et une vis (24) qui forme le dispositif de transport (2),
dans lequel le corps de base (11) comporte au moins un réceptacle (12) dans lequel est logé un contact électrique (3),
dans lequel le contact électrique (3) forme au moins deux zones de contact (31) qui dépassent du corps de base (11) sur des côtés opposés du corps de base (11),
dans lequel la vis (24) est réalisée sous forme allongée et présente un filetage externe (25) au moins par zones, et
dans lequel le corps de base (11) présente un alésage doté d'un filetage interne dans lequel le filetage externe (25) de la vis (24) peut être vissé,
dans lequel
le filetage interne du corps de base (11) est réalisé sous la forme d'un premier segment de filetage (15),
le dispositif de transport (2) comporte un premier support (21) à une première extrémité de la vis (24) et un second support (22) à une seconde extrémité de la vis (24), et
le filetage externe (25) de la vis (24) est réalisé sous la forme d'un second segment de filetage au-dessus d'une zone (26) sur le côté orienté vers le second support (22), et
le corps de base (11) présente une première ouverture (13) sur le côté opposé au premier segment fileté (15).

2. Système de contact glissant à mouvement linéaire et à dispositif de transport selon la revendication 1,
dans lequel le premier segment fileté (15) est réalisé dans une plage angulaire comprise entre 45 degrés et 180 degrés de l'alésage, de préférence dans une plage angulaire comprise entre 90 degrés et 180 degrés.

3. Système de contact glissant à mouvement linéaire et à dispositif de transport selon la revendication 1 ou 2,
dans lequel
le corps de base (11) présente une seconde ouverture (14) dans au moins une zone adjacente au premier segment fileté (15), dans lequel ladite au moins une seconde ouverture (14) est opposée à la première ouverture (13).

4. Système de contact glissant à mouvement linéaire et à dispositif de transport selon la revendication 1, dans lequel le dispositif de transport (2) comporte un dispositif d'accouplement (23) sur le côté du premier support (21) qui est opposé à la vis (24).

5. Système de contact glissant à mouvement linéaire et à dispositif de transport selon la revendication 1, dans lequel
le second segment de filetage est réalisé dans une plage angulaire comprise entre 180 degrés et 315 degrés autour de la vis, de préférence dans une plage angulaire comprise entre 180 degrés et 270 degrés.

6. Système de contact glissant à mouvement linéaire et à dispositif de transport selon la revendication 5, dans lequel
le premier segment fileté (15) et le second segment fileté procurent ensemble une plage angulaire comprise entre 350 degrés et 360 degrés.

7. Système de contact glissant à mouvement linéaire et à dispositif de transport selon la revendication 6, dans lequel
le premier segment fileté (15) et le second segment fileté sont chacun divisés en deux ou plusieurs plages angulaires, dans lequel les plages angulaires du premier segment fileté (15) et du second segment fileté peuvent être imbriquées.

8. Système de contact glissant à mouvement linéaire et à dispositif de transport selon l'une des revendications précédentes, dans lequel
le corps de base (11) est constitué d'un polymère électriquement isolant.

9. Système de contact glissant à mouvement linéaire et à dispositif de transport selon l'une des revendications précédentes, dans lequel
le dispositif de transport (2) est constitué d'un polymère électriquement isolant.

10. Procédé de fabrication d'un système de contact glissant à mouvement linéaire et à dispositif de transport selon l'une, des revendications précédentes, dans lequel
le corps de base (11) et le dispositif de transport (2) sont reliés l'un à l'autre par une barre (4) au cours d'un processus de moulage par injection en une seule pièce, et
deux contacts électriques 3, 3' sont insérés dans le corps de base 1, le dispositif de transport 2 est séparé du corps de base 1, inséré dans celui-ci puis est retourné de 180°.

11. Procédé selon la revendication 10, dans lequel la barre (4) est réalisée sous la forme de point destiné à la rupture.
